# EUROPEAN PATENT APPLICATION

(11) **EP 0 890 846 A2**
(43) Date of publication of application: **13.01.1999**
(21) Application number: 98305522.9
(22) Date of filing: 10.07.1998
(51) Int. Cl.: G01R 31/02, H02H 3/04

(54) **The monitoring of earth leakage faults**

(30) Priority: 11.07.1997 ZA 9706186
(71) Applicant: Circuit Breaker Industries Limited, Elandsfontein, Gauteng 1401 (ZA)
(72) Inventor: Bagalini, Dante, Johannesburg, Gauteng (SA); Nusse, Klaus Joachim, Randburg, Gauteng (SA); Grills, Terry Francis, Lonehill, Ext 13, Sandton, Gauting (SA)
(74) Representative: Mounteney, Simon James

(57) **Abstract**

An earth leakage (or ground) fault monitoring means (10) for monitoring the presence of an earth leakage fault, using an earth leakage fault detector (12) and a remote indicating means (16). The invention is for use in circumstances where automatic tripping could have undesirable results, and tripping or disconnecting of the circuit may then be controlled by authorised personnel. A latching arrangement (26) and reset device (22) are provided such that the indicating means (16) continues to indicate that there has been an earth fault even if the fault disappears, until the reset devise (22) has been operated. The earth leakage fault detector (12) and the indicating means (16) are in separate housings (36, 24). The latching arrangement (26) and the reset device (22) may then be in either housing. In a preferred embodiment the latching arrangement (26) includes a relay (28) having contactors (28.2, 28.3) that are supplied from a separate supply. Preferably, two light emitting (18, 20) devices may be used, one for indicating the presence or previous existence of a fault and the other a fault free condition.

## Description

**THIS INVENTION** relates to the monitoring of earth leakage faults. Such faults are also known as "ground faults".

According to a first aspect of the invention there is provided an earth leakage fault monitoring means for monitoring the presence of an earth leakage fault in a circuit which includes
an earth leakage fault detector; and
a remote indicating means responsive to the earth leakage fault detector for indicating the presence of an earth leakage fault.

Further according to the invention there is provided a method of monitoring the presence of an earth leakage fault in a circuit which includes
detecting the presence of an earth leakage fault; and
remotely indicating that there is an earth leakage fault.

By means of the invention, an earth leakage fault does not automatically trip a circuit in circumstances where tripping could have undesirable results, and tripping or disconnecting of the circuit may be controlled by authorised personnel.

The monitoring means may include a latching arrangement responsive to the earth leakage fault detector, interconnected between the earth leakage detector and the remote indicating means for energising the remote indicating means whilst there is an earth leakage fault thereafter; and a reset device whereby the latching means may be reset if there is no earth leakage fault detected by the earth leakage fault detector to de-energise the remote indicating means. Thus, in use, the remote indicating means will continue to indicate that there has been an earth leakage fault, even if the earth leakage fault disappears, until the reset device has been operated.

The earth leakage fault detector may be in a first housing and the remote indicating means may be in a separate, second housing. The latching arrangement may then be located in either the first housing or the second housing. The reset device will, preferably, be located in or on the second housing.

A relay may be used, which is operated by means of a fault signal supplied by the earth leakage fault detector. This relay may also be located in either the first housing or the second housing, although it is preferably in the first housing.

The relay may have potential free contactors. Thus, the relay may have one or more contactors that are supplied from a supply which is independent of the circuit being monitored.

The indicator means may have a pair of light emitting devices, one for indicating the presence (or previous existence) of a fault and the other for indicating a fault-free condition.

The monitoring means may also have a fault output which may be connectable to the shunt trip input of a separate circuit breaker, which may be remote. In this case, it will not be possible to reset the circuit breaker unless and until the reset device of the monitoring means has been operated and the fault is no longer there. By this means, unauthorised resetting of a circuit breaker that has tripped, is hindered.

The invention is now described by way of examples, with reference to the accompanying drawings in which:-
Figure 1 shows a first embodiment of an earth leakage monitoring means in accordance with the invention;
Figure 2 shows a second embodiment of an earth leakage monitoring means in accordance with the invention; and
Figure 3 shows a third embodiment of an earth leakage monitoring means in accordance with the invention.

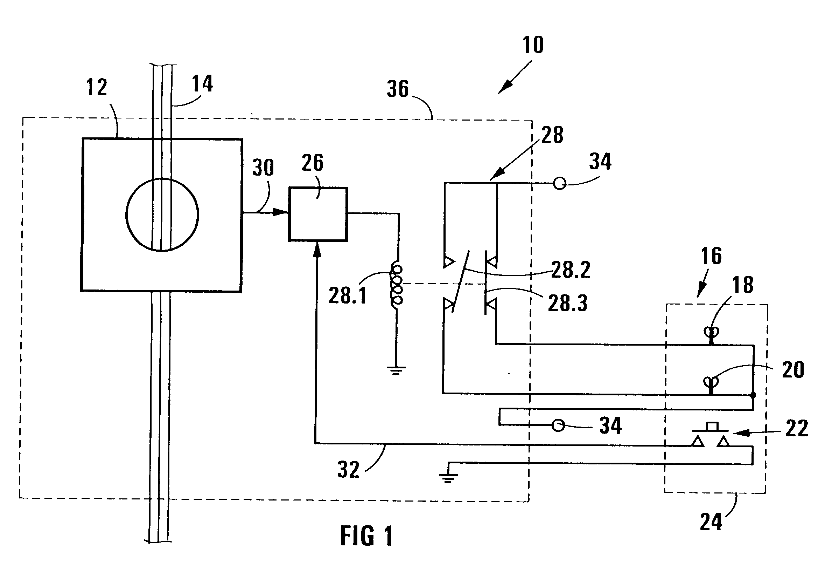

Referring to Figure 1, an earth leakage monitoring means in accordance with the invention is designated generally by reference numeral 10. The monitoring means 10 has a conventional earth leakage fault detector 12 which detects an imbalance of current in load current conductors 14. In addition, the monitoring means 10 has a remote indicating means 16.

The remote indicating means 16 has a green lamp 18 and a red lamp 20, as well as a normally open push button reset switch 22. The lamps 18 and 20 and the switch 22 are housed in a housing 24.

The monitoring means 10 further includes latching circuitry 26 and a two pole relay 28. The relay 28 has a coil 28.1 and two contactors 28.2 and 28.3. As seen, the contactor 28.2 is normally open and is connected to the red lamp 20; and the contactor 28.3 is normally closed and is connected to the green lamp 18.

The latching circuitry is supplied with a fault signal from the detector 12 via a conductor 30. It will also be seen that the reset switch 22 is connected to the latching circuitry via a conductor 32, such that the latching circuitry is reset upon operation of the switch 22.

Preferably, the lamps 20 and 22 are energised via a separate supply, and for this purpose power terminals 34 are provided. It will accordingly be appreciated that the contactors 28.2 and 28.3 are isolated from the power supply to the coil 28.1 and latching circuitry 26.

The detector 12, latching circuitry 26 and the relay 28 are housed in a detector housing 36. The indicator housing 24 is located remotely from the detector housing 36.

In operation, if an earth leakage fault is detected by the detector 12, then a fault signal is supplied to the latching circuitry 26. The latching circuitry 26 energises the coil 28.1 to operate the contactors 28.2 and 28.3. Thus, if there is no fault detected, the green lamp 20 is illuminated. If a fault is detected, the green lamp 20 is not energised and the red lamp 22 is, thereby indicating a fault. The red lamp 20 will continue to be energised even if the fault disappears, until the latching circuitry 26 is reset by depressing the switch 22. If the switch 22 is depressed and the fault is still present, the red lamp 20 will remain illuminated.

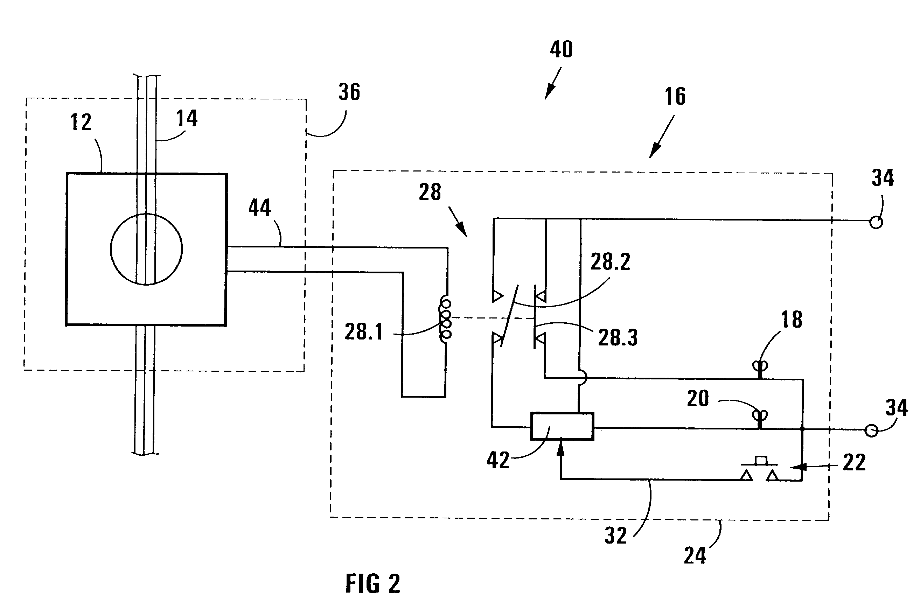

Referring now to Figure 2, a second embodiment of a monitoring means in accordance with the invention is designated generally by reference numeral 40. This embodiment is similar to the embodiment 10 shown in Figure 1 and similar components are referenced with the same numbers. The main difference between the embodiment 40 of Figure 2 and the embodiment 10 of Figure 1 is that the relay 28 and latching circuitry 42 are located in the indicator housing 24 and not in the detector housing 36. Thus, the latching circuitry 42 is supplied with power from the same supply as the lamps 20 and 22. With this embodiment 40, if a fault is detected and a fault signal supplied by the detector via conductor 44, the green lamp 18 is extinguished and the red lamp 20 is illuminated. If the fault disappears or is removed, the red lamp 20 will continue to be illuminated and the green lamp 22 will also be illuminated. Naturally, the red lamp will be extinguished if the reset switch 22 is operated and the fault is no longer there.

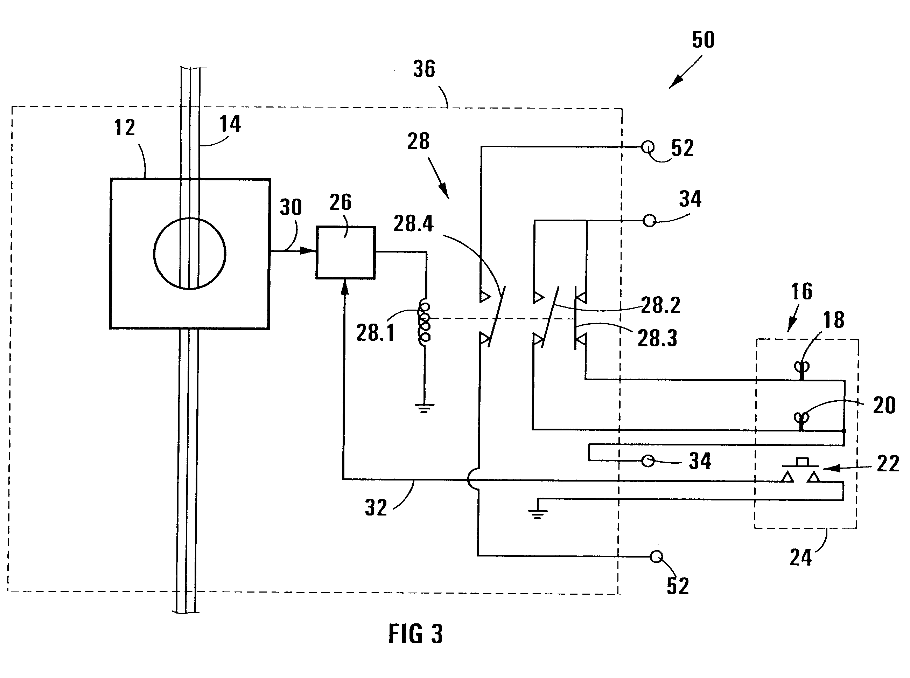

Referring to Figure 3, a third embodiment of a monitoring means is designated by reference numeral 50. This embodiment 50 is substantially similar to the embodiment 10 of Figure 1 and is similarly referenced. In addition, the relay 28 has a further normally open isolated contactor 28.4, which is connected to terminals 52. In use, these terminals 52 are connected to the shunt trip input of a remote circuit breaker (not shown). In this way, the circuit breaker will trip if there is an earth leakage fault, and it will only be possible to manually reset the circuit breaker if the reset switch 22 has been operated. Thus, unauthorised resetting of the circuit breaker may be controlled.

## Claims

1. An earth leakage fault monitoring means for monitoring the presence of an earth leakage fault in a circuit which includes
an earth leakage fault detector; and
a remote indicating means responsive to the earth leakage fault detector for indicating the presence of an earth leakage fault.

2. The earth leakage monitoring means as claimed in Claim 1, which includes
a latching arrangement responsive to the earth leakage fault detector interconnected between the earth leakage fault detector and the remote indicating means for energising the remote indicating means whilst there is an earth leakage fault and thereafter ; and
a reset device whereby the latching arrangement may be reset if there is no earth leakage fault detected by the earth leakage fault detector to de-energise the remote indicating means.

3. The earth leakage monitoring means claimed in Claim 2, which includes
a first housing in which the earth leakage fault detector is housed; and
a second housing in which the remote indicating means is housed.

4. The earth leakage monitoring means claimed in Claim 3, in which the latching arrangement is housed in the first housing.

5. The earth leakage monitoring means claimed in Claim 3, in which the latching arrangement is housed in the second housing.

6. The earth leakage monitoring means claimed in Claim 3, in which the reset device is housed in the second housing.

7. The earth leakage monitoring means claimed in Claim 3, in which the latching arrangement includes a relay which is operated by means of a fault signal supplied by the earth leakage fault detector.

8. The earth leakage monitoring means claimed in Claim 7, in which the relay has at least one contactor that is connectable to a supply which is independent of the circuit being monitored.

9. The earth leakage monitoring means claimed in Claim 1, in which the remote indicating means includes a pair of light emitting devices, one for indicating that a fault has occurred and the other for indicating a fault free condition.

10. The earth leakage monitoring means claimed in Claim 2, in which the latching arrangement has a fault output which is connectable to a shunt trip input of a separate circuit breaker.

11. A method of monitoring the presence of an earth leakage fault in a circuit which includes
detecting the presence of an earth leakage fault; and
remotely indicating that there is an earth leakage fault.

12. The method of monitoring the presence of an earth leakage fault as claimed in Claim 11, which includes
energising an indicating means by means of a latching arrangement whilst there is an earth leakage fault and thereafter; and
resetting the latching arrangement if there is no earth leakage fault detected to de-energise the indicating means.

13. The method of monitoring the presence of an earth leakage fault as claimed in Claim 12, which includes supplying the latching arrangement from a supply which is independent of the circuit being monitored.

14. The method of monitoring the presence of an earth leakage fault as claimed in Claim 12, which includes supplying a fault output signal from the latching arrangement to a shunt trip input of a separate circuit breaker.
